# EUROPEAN PATENT APPLICATION

(11) **EP 4 304 317 A1**
(43) Date of publication of application: **10.01.2024**
(21) Application number: 22206543.5
(22) Date of filing: 10.11.2022
(51) Int. Cl.: H10K 30/10, H10K 30/40, H10K 30/85

(54) **PEROVSKITE SOLAR CELL AND PREPARATION METHOD THEREFOR**

(30) Priority: 07.07.2022 CN 202210794449
(71) Applicant: China Three Gorges Co., Ltd., Wuhan Hubei 430010 (CN); Ludong University, Yantai City, Shandong 264011 (CN)
(72) Inventor: WU, Yunyi, Wuhan, 430010 (CN); ZHANG, Shufang, Wuhan, 430010 (CN); YIN, Likun, Wuhan, 430010 (CN); GENG, Quanming, Wuhan, 430010 (CN); JIA, Xiangrui, Wuhan, 430010 (CN)
(74) Representative: M. Zardi & Co S.A.

(57) **Abstract**

Disclosed in the present invention are a perovskite solar cell and a preparation method therefor, which belongs to the technical field of solar cells and overcomes the defect that a perovskite thin film cell in the art has a small grain size, thus leading to interfacial defects, which hinders the photoelectric conversion rate of the cell. The perovskite solar cell of the present invention is sequentially provided with a bottom electrode, an electron transport layer modified by a metal chelating chromogenic agent, a perovskite light-absorbing layer, a hole transport layer and a top electrode. By means of the present invention, the photoelectric conversion efficiency of the perovskite solar cell may be improved.

## Description

### TECHNICAL FIELD

The present invention belongs to the technical field of solar cells, and specifically relates to a perovskite solar cell and a preparation method therefor.

### BACKGROUND

An organic/inorganic perovskite solar cell has excellent photoelectric performance as a next-generation photovoltaic device, thus attracting much attention of scientific researchers. A perovskite material, which is used as a solar cell light-absorbing material, has not only high efficiency in light absorption and carrier mobility, but also a tunable band gap, making it an excellent photovoltaic material that has attracted a lot of attention. On the basis of the above excellent performance, the perovskite material may be used as a light-absorbing material acting in a photovoltaic device. The solar photovoltaic industry has a broad development prospect in the photoelectric field. As a research hotspot in the field of solar power generation, the photoelectric conversion efficiency of a perovskite solar cell has been dramatically improved to 25.7% in just over a decade.

In recent years, there has been great progress in the preparation technology for a perovskite thin film which has the advantages of simple preparation and good crystallization. However, at present, there are still some problems, such as the small grain size of a thin film in a perovskite light-absorbing layer. These problems may lead to interfacial defects (such as defects existing between the grains of the perovskite thin film, and between interfaces of the perovskite thin film and an adjacent functional layer). The interfacial defects are directly related to the performance of a cell. The interfacial defects may affect the current transfer in a device and may generate non-radiative recombination, ultimately leading to relatively low photoelectric conversion efficiency of a solar cell.

### SUMMARY

Therefore, the technical problem to be solved by the present invention lies in overcoming the defect that a perovskite thin film cell in the art has a small grain size, thus leading to interfacial defects, which hinders the photoelectric conversion rate of the cell. Thus, provided are a perovskite solar cell and a preparation method therefor.

Therefore, the following technical solution is provided in the present invention.

In a first aspect, provided in the present invention is a perovskite solar cell, which is sequentially provided with a bottom electrode, an electron transport layer modified by a metal chelating chromogenic agent, a perovskite light-absorbing layer, a hole transport layer and a top electrode.

Further, the metal chelating chromogenic agent is at least one of amino black 10B, Ponceau S, Coomassie brilliant blue and bathophenanthrolinedisulfonate; and/or
the bottom electrode material is FTO conductive glass or ITO conductive glass; and/or
the top electrode material is one of gold, silver or copper; and/or
the top electrode has a thickness of 80-100 nm.

In a second aspect, provided in the present invention is a preparation method for a perovskite solar cell, including the following steps:
step 1, preparing an electron transport layer on a bottom electrode;
step 2, coating the surface of the electron transport layer with a solution of a metal chelating chromogenic agent, and performing annealing treatment to form an electron transport layer modified by the metal chelating chromogenic agent;
step 3, preparing a perovskite light-absorbing layer on the electron transport layer modified by the metal chelating chromogenic agent;
step 4, preparing a hole transport layer on the perovskite light-absorbing layer; and
step 5, preparing a top electrode on the hole transport layer.

Further, in the step 2, the annealing treatment time is 5-10 min, and the annealing treatment temperature is 100±10°C.

Further, the step 1 includes: spin-coating a tin oxide solution onto the bottom electrode, and performing annealing treatment to prepare the electron transport layer; and
in the step 1, the annealing temperature is 140-160°C, and the annealing time is 25-35 min.

Further, the step 3 includes: spin-coating a mixed solution of lead halide and cesium iodide, and a perovskite precursor solution on the electron transport layer modified by the metal chelating chromogenic agent; and performing annealing treatment to obtain the perovskite light-absorbing layer.

Further, in the step 3, the mixed solution of lead halide and cesium iodide is firstly spin-coated, and the perovskite precursor solution is then spin-coated; and the annealing treatment time is 8-12 min, and the annealing treatment temperature is 100±10°C.

Further, at least one of conditions A-G is satisfied:
A, the lead halide is at least one of lead iodide, lead bromide and lead chloride;
B, a solvent of the mixed solution of lead halide and cesium iodide is at least one of dimethylformamide, chlorobenzene and dimethyl sulfoxide;
C, a mass ratio of lead halide to cesium iodide in the mixed solution of lead halide and cesium iodide is (5-25):(0.2-1.0);
D, the perovskite precursor solution is a mixed solution of ammonium salts including formamidine iodide, methyl ammonium iodide, methyl ammonium bromide and methyl ammonium chloride; wherein
   a mass ratio of formamidine iodide to methyl ammonium iodide to methyl ammonium bromide to methyl ammonium chloride in the perovskite precursor solution is (2-8):(1-4):(0.25-1.0):(0.25-1.0);
   E, a solvent of the perovskite precursor solution is isopropyl alcohol, chlorobenzene or dimethyl sulfoxide;
   F, in the step 2, a solvent of the solution of the metal chelating chromogenic agent is at least one of ethanol, isopropanol, chlorobenzene and water; and
   G, in the step 2, the concentration of the solution of the metal chelating chromogenic agent is 0.3-2.0 mg/ml.

Further, the step 4 includes: spin-coating a Spiro-OMeTAD solution on the perovskite light-absorbing layer to prepare the hole transport layer.

Further, the step 5 includes: preparing the top electrode on the hole transport layer by vacuum evaporation.

The perovskite precursor solution includes formamidine iodide (FAI, CH(NH₂)₂I), methyl ammonium iodide (MAI, CH₃NH₃I), methyl ammonium bromide (MABr, CH₃NH₃Br) and methyl ammonium chloride (MACl, CH₃NH₃Cl); and a solvent of the perovskite precursor solution is isopropyl alcohol (IPA), chlorobenzene (CB) or dimethyl sulfoxide (DMSO).

The technical solution of the present invention has the following advantages:
1. the perovskite solar cell provided in the present invention is sequentially provided with the bottom electrode, the electron transport layer modified by the metal chelating chromogenic agent, the perovskite light-absorbing layer, the hole transport layer and the top electrode. According to the present invention, the metal chelating chromogenic agent is used to modify the electron transport layer, and the metal chelating chromogenic agent may fill a gap in the surface of the electron transport layer and improve the flatness of the electron transport layer, thus reducing interfacial defects between the electron transport layer and the perovskite light-absorbing layer. By modifying an interface, the charge accumulation at the interface is adjusted and the crystallization size of perovskite is increased, thus remedying deep defects between the electron transport layer and a thin film of the perovskite light-absorbing layer thin film. In addition, a perovskite interface is bridged, and interface charges are effectively adjusted to reduce the hysteresis effect of a device, thus improving the photoelectric conversion efficiency of the perovskite solar cell, and solving the problem that interfacial defects hinder the performance of the perovskite solar cell.
2. The preparation method for the perovskite solar cell provided in the present invention includes the following steps: step 1, preparing the electron transport layer on the bottom electrode; step 2, coating the surface of the electron transport layer with the solution of the metal chelating chromogenic agent, and performing annealing treatment to form the electron transport layer modified by the metal chelating chromogenic agent; step 3, preparing the perovskite light-absorbing layer on the electron transport layer modified by the metal chelating chromogenic agent; step 4, preparing the hole transport layer on the perovskite light-absorbing layer; and step 5, preparing the top electrode on the hole transport layer.
   A chromogenic agent chelator solution is added to the surface of the prepared electron transport layer, so as to obtain an electron transport layer having a flat surface. Meanwhile, the metal chelating chromogenic agent will generate crystal clusters, and more trapping sites will be generated, thus promoting the formation of a perovskite light-absorbing layer having large grains. The metal chelating chromogenic agent may attract metal ions in the electron transport layer and the perovskite light-absorbing layer, thus promoting the generation of grains, and being more favorable to crystal growth compared with a device without a metal chelating agent. In the perovskite solar cell prepared by using the method of the present invention, the electron transport layer has high flatness, and the perovskite light-absorbing layer has a large grain size, thus remedying the problem of more interfacial defects in the perovskite solar cell and significantly improving the photoelectric conversion efficiency of a device. Compared with a comparative device, the photoelectric conversion efficiency of a modified device of the present invention is improved by 20% or more.
3. According to the preparation method for the perovskite solar cell provided in the present invention, the step 3 includes: spin-coating the mixed solution of lead halide and cesium iodide, and the perovskite precursor solution on the electron transport layer modified by the metal chelating chromogenic agent; and performing annealing treatment to obtain the perovskite light-absorbing layer.

The metal chelating chromogenic agent may generate crystal clusters, so as to obtain a lead halide thin film having a large grain size. On the basis of the lead halide thin film having a relatively large grain size and a sufficient crystallization space, the lead halide thin film reacts sufficiently with the perovskite precursor solution, so as to obtain the perovskite light-absorbing layer having large grains. The perovskite light-absorbing layer in the perovskite solar cell prepared by using the method of the present invention has high flatness and large and uniform grains.

### BRIEF DESCRIPTION OF THE DRAWINGS

In order to illustrate the technical solutions in the specific embodiments of the present invention or in the prior art more clearly, the drawings to be used in the description of the specific embodiments or the prior art will be briefly introduced below. Obviously, the drawings in the following description show some of the embodiments of the present invention, and those of ordinary skill in the art may still obtain other drawings from these drawings without creative efforts.
Fig. 1 is a comparison diagram of J-V curves obtained by testing perovskite solar cell prepared in Example 1 and Comparative example 1.
Fig. 2 is a comparison diagram of J-V curves obtained by testing perovskite solar cells prepared in Example 2 and Comparative example 2.
Fig. 3 is a comparison diagram of J-V curves obtained by testing perovskite solar cells prepared in Example 3 and Comparative example 3.
Fig. 4 is a comparison diagram of J-V curves obtained by testing perovskite solar cells prepared in Example 4 and Comparative example 4.
Fig. 5 is a comparison diagram of J-V curves obtained by testing perovskite solar cells prepared in Example 5 and Comparative example 5.
Fig. 6 is a comparison diagram of J-V curves obtained by testing perovskite solar cells prepared in Example 6 and Comparative example 6.
Fig. 7 is a scanning electron microscope image obtained by testing a perovskite thin film prepared in Comparative example 1.
Fig. 8 is a scanning electron microscope image obtained by testing a perovskite thin film prepared in Example 1.
Fig. 9 is a schematic structural diagram of the perovskite solar cell prepared in Examples 1-6.

### DETAILED DESCRIPTION

The following embodiments are provided for a better understanding of the present invention, are not limited to the best implementations, and do not constitute a limitation on the content or scope of protection of the present invention. Any product identical or similar to the present invention, derived by anyone under the inspiration of the present invention or by combining the present invention with other features of the prior art, falls within the scope of protection of the present invention.

Where specific experimental steps or conditions are not indicated in the embodiments, the operations or conditions of conventional experimental steps described in the documents in the art can be followed. The reagents or instruments used without the manufacturer indicated are conventional reagent products that can be commercially available.

Regarding raw materials in the embodiments and the comparative examples, lead iodide (PbI₂, 99.99%) and formamidine iodide (FAI) are purchased from Xi'an Polymer Light Technology Corp.; a 15 wt% SnO₂ colloidal solution (a mass fraction of SnO₂ in H₂O colloidal dispersion is 15%) is purchased from Alpha-Iso; a Spiro-OMeTAD solution and FTO conductive glass are purchased from Liaoning Youxuan Company; and the remaining drugs such as methyl ammonium iodide (MAI, CH₃NH₃I), methyl ammonium bromide (MABr, CH₃NH₃Br), methyl ammonium chloride (MACl, CH₃NH₃Cl), isopropyl alcohol (IPA), N,N-dimethylformamide (DMF), dimethyl sulfoxide (DMSO), amino black 10B, Ponceau S, Coomassie brilliant blue or bathophenanthrolinedisulfonate are all purchased from TCI. All salts and solvents are used as received without further purification.

### EXAMPLE 1

Provided in this embodiment is a preparation method for a perovskite solar cell, including the following steps:
1) ultrasonically cleaning FTO conductive glass respectively by using soapy water, deionized water, anhydrous ethanol and acetone, and then performing ultraviolet ozone cleaning;
2) diluting a 15 wt% SnO₂ colloidal solution with deionized water to obtain a 3.75 wt% SnO₂ colloidal solution; sucking the prepared tin oxide colloidal solution of 3.75 wt% with a rubber-tipped dropper, spin-coating the tin oxide colloidal solution at 4000 rpm for 35 s after overspreading the FTO conductive glass, and then performing annealing at 140°C for 35 min to prepare an electron transport layer; and dissolving 0.5 mg of a metal chelating chromogenic agent, i.e. amino black 10B, in 1 ml of anhydrous ethanol, sucking this solution with a rubber-tipped dropper to overspread the FTO conductive glass coated with the electron transport layer, spin-coating the solution at 3000 rpm for 30 s, and performing annealing at 100°C for 10 min;
3) dissolving PbI₂ (7.50 g) and CsI (0.30 g) in 11400 µL of DMF and 600 µL of DMSO, and performing vigorous stirring at 500 rpm for 5 h at room temperature to obtain a mixed solution of lead iodide and cesium iodide; dissolving FAI (0.60 g), MAI (0.30 g), MABr (0.075 g) and MACl (0.075 g) in 15 ml of IPA, and performing vigorous stirring at 500 rpm for 5 h at room temperature to obtain a perovskite precursor solution; adding dropwise 50 µL of the mixed solution of lead iodide and cesium iodide with a pipette, and adjusting parameters of a spin coater to be 3000 rpm and 30 s; statically adding dropwise 100 µL of the perovskite precursor solution on a thin film coated with the mixed solution of lead iodide and cesium iodide with a pipette, with the parameters of the spin coater being 3000 rpm and 30 s; and finally, performing heating annealing at a temperature of 100°C for 12 min;
4) spin-coating a Spiro-OMeTAD solution in a glove box: adding dropwise 50 µL of the Spiro-OMeTAD solution on a perovskite light-absorbing layer, with the parameters of the spin coater being 3000 rpm and 30 s; and
5) finally, evaporating a silver electrode: preparing a top electrode on the perovskite light-absorbing layer by using a vacuum evaporation method, wherein a material of the top electrode in this embodiment is silver, and the thickness of the silver electrode is 80 nm.

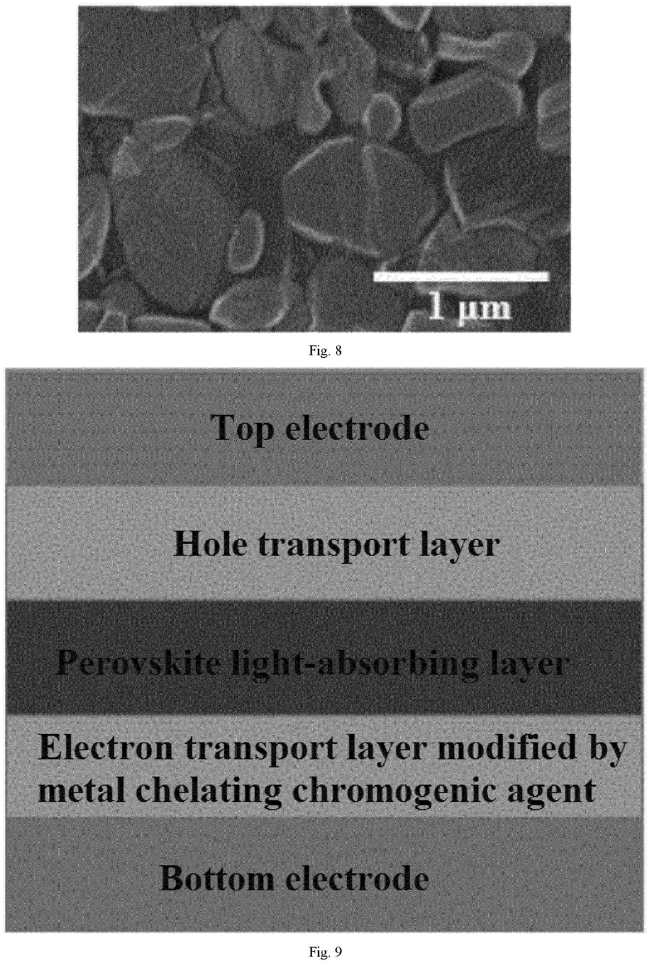

The prepared perovskite solar cell is shown in Fig. 9.

### EXAMPLE 2

Provided in this is a preparation method for a perovskite solar cell, including the following steps:
1) ultrasonically cleaning FTO conductive glass respectively by using soapy water, deionized water, anhydrous ethanol and acetone, and then performing ultraviolet ozone cleaning;
2) diluting a 15 wt% SnO₂ colloidal solution with deionized water to obtain a 3.75 wt% SnO₂ colloidal solution; sucking the prepared tin oxide colloidal solution of 3.75 wt% with a rubber-tipped dropper, spin-coating the tin oxide colloidal solution at 4000 rpm for 35 s after overspreading the FTO conductive glass, and then performing annealing at 150°C for 30 min to prepare an electron transport layer; and dissolving 0.5 mg of a metal chelating chromogenic agent, i.e. bathophenanthrolinedisulfonate, in 1 ml of anhydrous ethanol, sucking this solution with a rubber-tipped dropper to overspread the FTO conductive glass coated with the electron transport layer, spin-coating the solution at 3000 rpm for 30 s, and performing annealing at 100°C for 10 min;
3) dissolving PbI₂ (7.50 g) and CsI (0.30 g) in 11400 µL of DMF and 600 µL of DMSO, and performing vigorous stirring at 500 rpm for 5 h at room temperature to obtain a mixed solution of lead iodide and cesium iodide; dissolving FAI (0.60 g), MAI (0.30 g), MABr (0.075 g) and MACl (0.075 g) in 15 ml of IPA, and performing vigorous stirring at 500 rpm for 5 h at room temperature to obtain a perovskite precursor solution; adding dropwise 50 µL of the mixed solution of lead iodide and cesium iodide with a pipette, and adjusting parameters of a spin coater to be 3000 rpm and 30 s; statically adding dropwise 100 µL of the perovskite precursor solution on a thin film coated with the mixed solution of lead iodide and cesium iodide with a pipette, with the parameters of the spin coater being 3000 rpm and 30 s; and finally, performing heating annealing at a temperature of 100°C for 12 min;
4) spin-coating a Spiro-OMeTAD solution in a glove box: adding dropwise 50 µL of the Spiro-OMeTAD solution on a perovskite light-absorbing layer, with instrument parameters being 3000 rpm and 30 s; and
5) finally, evaporating a silver electrode: preparing a top electrode on the perovskite light-absorbing layer by using a vacuum evaporation method, wherein a material of the top electrode is silver, and the thickness of the silver electrode in the solution is 80 nm.

The prepared perovskite solar cell is shown in Fig. 9.

### EXAMPLE 3

Provided in this embodiment is a preparation method for a perovskite solar cell, including the following steps:
1) ultrasonically cleaning FTO conductive glass respectively by using soapy water, deionized water, anhydrous ethanol and acetone, and then performing ultraviolet ozone cleaning;
2) diluting a 15 wt% SnO₂ colloidal solution with deionized water to obtain a 3.75 wt% SnO₂ colloidal solution; sucking the prepared tin oxide colloidal solution of 3.75 wt% with a rubber-tipped dropper, spin-coating the tin oxide colloidal solution at 4000 rpm for 35 s after overspreading the FTO conductive glass, and then performing annealing at 160°C for 35 min to prepare an electron transport layer; and dissolving 0.5 mg of a metal chelating chromogenic agent, i.e. amino black 10B, in 1 ml of anhydrous ethanol, sucking this solution with a rubber-tipped dropper to overspread the FTO conductive glass coated with the electron transport layer, spin-coating the solution at 3000 rpm for 30 s, and performing annealing at 100°C for 10 min;
3) dissolving PbI₂ (7.20 g) and CsI (0.40 g) in 11400 µL of DMF and 600 µL of DMSO, and performing vigorous stirring at 500 rpm for 5 h at room temperature to obtain a mixed solution of lead iodide and cesium iodide; dissolving FAI (0.50 g), MAI (0.20 g), MABr (0.06 g) and MACl (0.06 g) in 15 ml of IPA, and performing vigorous stirring at 500 rpm for 5 h at room temperature to obtain a perovskite precursor solution; adding dropwise 50 µL of the mixed solution of lead iodide and cesium iodide with a pipette, and adjusting parameters of a spin coater to be 3000 rpm and 30 s; statically adding dropwise 100 µL of the perovskite precursor solution on a thin film coated with the mixed solution of lead iodide and cesium iodide with a pipette, with the parameters of the spin coater being 3000 rpm and 30 s; and finally, performing heating annealing at a temperature of 100°C for 12 min;
4) spin-coating a Spiro-OMeTAD solution in a glove box: adding dropwise 50 µL of the Spiro-OMeTAD solution on a perovskite light-absorbing layer, with instrument parameters being 3000 rpm and 30 s; and
5) finally, evaporating a silver electrode: preparing a top electrode on the perovskite light-absorbing layer by using a vacuum evaporation method, wherein a material of the top electrode is silver, and the thickness of the silver electrode in the solution is 90 nm.

The prepared perovskite solar cell is shown in Fig. 9.

### EXAMPLE 4

Provided in this embodiment is a preparation method for a perovskite solar cell, including the following steps:
1) ultrasonically cleaning FTO conductive glass respectively by using soapy water, deionized water, anhydrous ethanol and acetone, and then performing ultraviolet ozone cleaning;
2) diluting a 15 wt% SnO₂ colloidal solution with deionized water to obtain a 3.75 wt% SnO₂ colloidal solution; sucking the prepared tin oxide colloidal solution of 3.75 wt% with a rubber-tipped dropper, spin-coating the tin oxide colloidal solution at 4000 rpm for 35 s after overspreading the FTO conductive glass, and then performing annealing at 140°C for 35 min to prepare an electron transport layer; and dissolving 1.0 mg of a metal chelating chromogenic agent, i.e. amino black 10B, in 1 ml of deionized water, sucking this solution with a rubber-tipped dropper to overspread the FTO conductive glass coated with the electron transport layer, spin-coating the solution at 3000 rpm for 30 s, and performing annealing at 110°C for 8 min;
3) dissolving PbI₂ (8 g) and CsI (0.20 g) in 11400 µL of DMF and 600 µL of DMSO, and performing vigorous stirring at 500 rpm for 5 h at room temperature to obtain a mixed solution of lead iodide and cesium iodide; dissolving FAI (0.70 g), MAI (0.40 g), MABr (0.09 g) and MACl (0.09 g) in 15 ml of IPA, and performing vigorous stirring at 500 rpm for 5 h at room temperature to obtain a perovskite precursor solution; adding dropwise 50 µL of the mixed solution of lead iodide and cesium iodide with a pipette, and adjusting parameters of a spin coater to be 3000 rpm and 30 s; statically adding dropwise 100 µL of the perovskite precursor solution on a thin film coated with the mixed solution of lead iodide and cesium iodide with a pipette, with the parameters of the spin coater being 3000 rpm and 30 s; and finally, performing heating annealing at a temperature of 110°C for 8 min;
4) spin-coating a Spiro-OMeTAD solution in a glove box: adding dropwise 50 µL of the Spiro-OMeTAD solution on a perovskite light-absorbing layer, with instrument parameters being 3000 rpm and 30 s; and
5) finally, evaporating a gold electrode: preparing a top electrode on the perovskite light-absorbing layer by using a vacuum evaporation method, wherein a material of the top electrode is gold, and the thickness of a gold electrode in the solution is 100 nm.

The prepared perovskite solar cell is shown in Fig. 9.

### EXAMPLE 5

Provided in this embodiment is a preparation method for a perovskite solar cell, including the following steps:
1) ultrasonically cleaning FTO conductive glass respectively by using soapy water, deionized water, anhydrous ethanol and acetone, and then performing ultraviolet ozone cleaning;
2) diluting a 15 wt% SnO₂ colloidal solution with deionized water to obtain a 3.75 wt% SnO₂ colloidal solution; sucking the prepared tin oxide colloidal solution of 3.75 wt% with a rubber-tipped dropper, spin-coating the tin oxide colloidal solution at 4000 rpm for 35 s after overspreading the ITO conductive glass, and then performing annealing at 150°C for 30 min to prepare an electron transport layer; and dissolving 0.5 mg of a metal chelating chromogenic agent, i.e. Ponceau S, in 1 ml of isopropanol, sucking this solution with a rubber-tipped dropper to overspread the FTO conductive glass coated with the electron transport layer, spin-coating the solution at 3000 rpm for 30 s, and performing annealing at 110°C for 8 min;
3) dissolving PbBr₂ (7.50 g) and CsI (0.30 g) in 11400 µL of chlorobenzene and 600 µL of DMSO, and performing vigorous stirring at 500 rpm for 5 h at room temperature to obtain a mixed solution of lead bromide and cesium iodide; dissolving FAI (0.60 g), MAI (0.30 g), MABr (0.075 g) and MACl (0.075 g) in 15 ml of DMSO, and performing vigorous stirring at 500 rpm for 5 h at room temperature to obtain a perovskite precursor solution; adding dropwise 50 µL of the mixed solution of lead bromide and cesium iodide with a pipette, and adjusting parameters of a spin coater to be 3000 rpm and 30 s; statically adding dropwise 100 µL of the perovskite precursor solution on a thin film coated with the mixed solution of lead bromide and cesium iodide with a pipette, with the parameters of the spin coater being 3000 rpm and 30 s; and finally, performing heating annealing at a temperature of 110°C for 8 min;
4) spin-coating a Spiro-OMeTAD solution in a glove box: adding dropwise 50 µL of the Spiro-OMeTAD solution on a perovskite light-absorbing layer, with instrument parameters being 3000 rpm and 30 s; and
5) finally, evaporating a gold electrode: preparing a top electrode on the perovskite light-absorbing layer by using a vacuum evaporation method, wherein a material of the top electrode is gold, and the thickness of the gold electrode in the solution is 80 nm.

The prepared perovskite solar cell is shown in Fig. 9.

### EXAMPLE 6

Provided in this embodiment is a preparation method for a perovskite solar cell, including the following steps:
1) ultrasonically cleaning FTO conductive glass respectively by using soapy water, deionized water, anhydrous ethanol and acetone, and then performing ultraviolet ozone cleaning;
2) diluting a 15 wt% SnO₂ colloidal solution with deionized water to obtain a 3.75 wt% SnO₂ colloidal solution; sucking the prepared tin oxide colloidal solution of 3.75 wt% with a rubber-tipped dropper, spin-coating the tin oxide colloidal solution at 4000 rpm for 35 s after overspreading the FTO conductive glass, and then performing annealing at 160°C for 25 min to prepare an electron transport layer; and dissolving 0.75 mg of a metal chelating chromogenic agent, i.e. Coomassie brilliant blue, in 1 ml of chlorobenzene, sucking this solution with a rubber-tipped dropper to overspread the FTO conductive glass coated with the electron transport layer, spin-coating the solution at 3000 rpm for 30 s, and performing annealing at 110°C for 8 min;
3) dissolving PbCl₂ (7.50 g) and CsI (0.30 g) in 11400 µL of DMF and 600 µL of DMSO, and performing vigorous stirring at 500 rpm for 5 h at room temperature to obtain a mixed solution of lead chloride and cesium iodide; dissolving FAI (0.60 g), MAI (0.30 g), MABr (0.075 g) and MACl (0.075 g) in 15 ml of IPA, and performing vigorous stirring at 500 rpm for 5 h at room temperature to obtain a perovskite precursor solution; adding dropwise 50 µL of the mixed solution of lead chloride and cesium iodide with a pipette, and adjusting parameters of a spin coater to be 3000 rpm and 30 s; statically adding dropwise 100 µL of the perovskite precursor solution on a thin film coated with the mixed solution of lead chloride and cesium iodide with a pipette, with the parameters of the spin coater being 3000 rpm and 30 s; and finally, performing heating annealing at a temperature of 110°C for 8 min;
4) spin-coating a Spiro-OMeTAD solution in a glove box: adding dropwise 50 µL of the Spiro-OMeTAD solution on a perovskite thin film, with instrument parameters being 3000 rpm and 30 s; and
5) finally, evaporating a copper electrode: preparing a top electrode on the perovskite thin film by using a vacuum evaporation method, wherein a material of the top electrode is copper, and the thickness of the copper electrode in the solution is 80 nm.

The prepared perovskite solar cell is shown in Fig. 9.

### COMPARATIVE EXAMPLE 1

This comparative example provides a preparation method for a perovskite solar cell, which is basically the same as that in Example 1. The difference lies in that an electron transport layer is not modified by using a metal chelating chromogenic agent, and the remaining steps are the same as those in Example 1.

### COMPARATIVE EXAMPLE 2

This comparative example provides a preparation method for a perovskite solar cell, which is basically the same as that in Example 2. The difference lies in that an electron transport layer is not modified by using a metal chelating chromogenic agent, and the remaining steps are the same as those in Example 2.

### COMPARATIVE EXAMPLE 3

This comparative example provides a preparation method for a perovskite solar cell, which is basically the same as that in Example 3. The difference lies in that an electron transport layer is not modified by using a metal chelating chromogenic agent, and the remaining steps are the same as those in Example 3.

### COMPARATIVE EXAMPLE 4

This comparative example provides a preparation method for a perovskite solar cell, which is basically the same as that in Example 4. The difference lies in that an electron transport layer is not modified by using a metal chelating chromogenic agent, and the remaining steps are the same as those in Example E 4.

### COMPARATIVE EXAMPLE 5

This comparative example provides a preparation method for a perovskite solar cell, which is basically the same as that in Example 5. The difference lies in that an electron transport layer is not modified by using a metal chelating chromogenic agent, and the remaining steps are the same as those of Example 5.

### COMPARATIVE EXAMPLE 6

This comparative example provides a preparation method for a perovskite solar cell, which is basically the same as that in Example 6. The difference lies in that an electron transport layer is not modified by using a metal chelating chromogenic agent, and the remaining steps are the same as those in Example 6.

### TEST EXAMPLE

### 1) Photoelectric conversion efficiency test:

The photoelectric conversion efficiency of the perovskite solar cells prepared in Examples 1-6 and Comparative examples 1-6 is tested. A test method includes: testing the cell conversion efficiency by using an electrochemical workstation; calibrating a light intensity to AM1.5G-one sun condition (100 mW/cm²) by using a NIM-calibrated standard silicon solar cell; using a metal mask to define the effective active area of a solar cell device prepared in the Examples and the comparative examples to be 0.09 cm²; and performing measurement for a J-V curve at a scan rate of 100 mV/s within the range of 1.2 V-0.1 V.

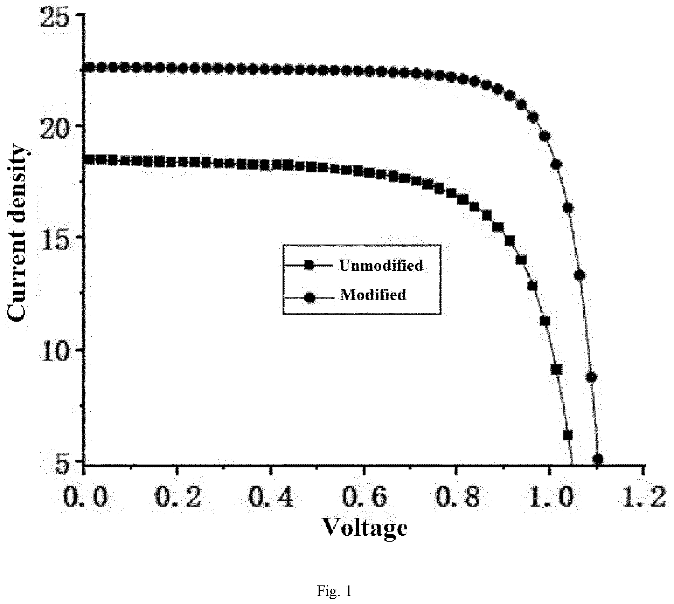

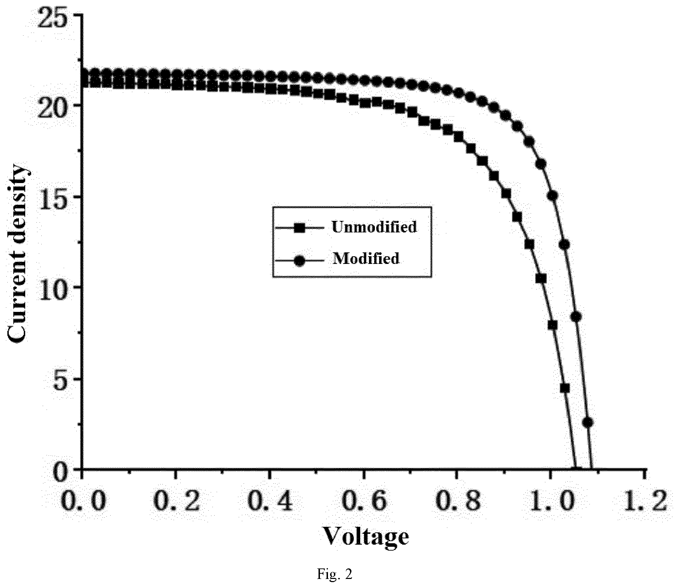

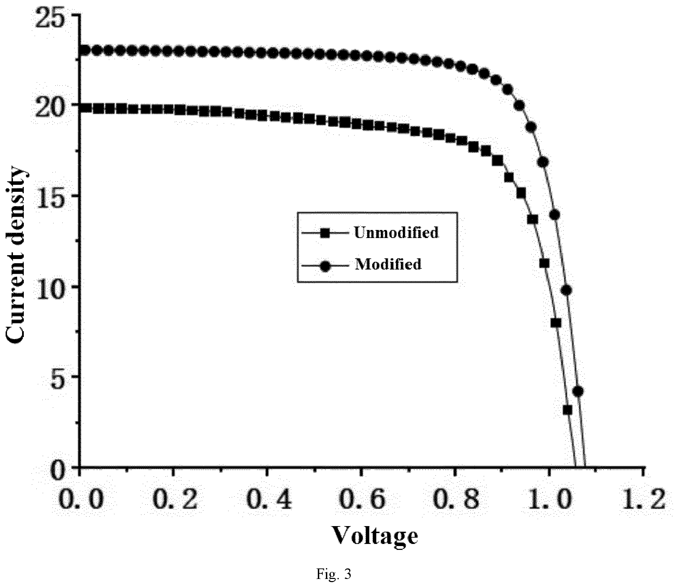

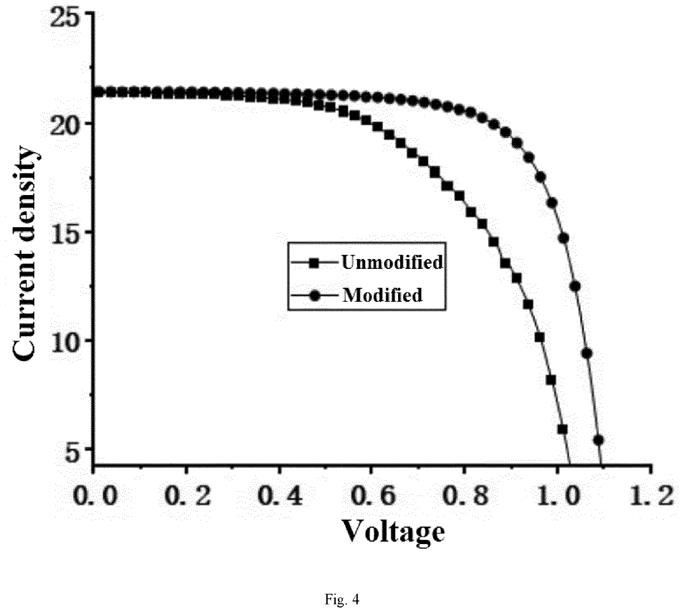

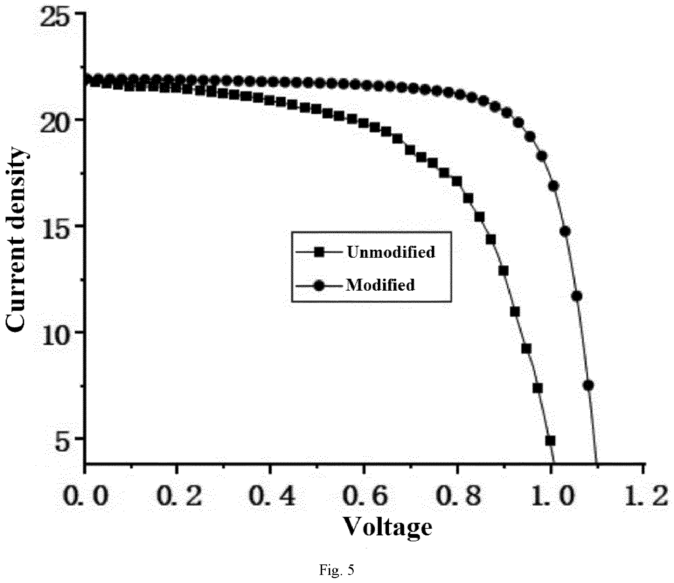

The J-V curves are shown in Figs. 1-6. The photoelectric conversion efficiency of a solar cell is the maximum area of a rectangle formed by points on a curve. The photoelectric conversion efficiency of the solar cell is shown in Table 1. Photoelectric conversion efficiency increase rate = (photoelectric conversion efficiency in an embodiment-photoelectric conversion efficiency in the corresponding comparative example)/photoelectric conversion efficiency in the corresponding comparative example.

**Table 1 Photoelectric conversion efficiency of solar cells**

| | Photoelectric conversion efficiency (%) | | Photoelectric conversion efficiency increase rate | |
|---|---|---|---|---|
| COMPARATIVE EXAMPLE 1 | | 13.80% | | |
| EXAMPLE 1 | | 19.67% | | 43% |
| COMPARATIVE EXAMPLE 2 | | 14.68% | | |
| EXAMPLE 2 | | 17.57% | | 20% |
| COMPARATIVE | | 15.21% | | |
| EXAMPLE 3 | | | | |
| EXAMPLE 3 | | 19.02% | | 25% |
| COMPARATIVE EXAMPLE 4 | | 13.10% | | |
| EXAMPLE 4 | | 17.39% | | 33% |
| COMPARATIVE EXAMPLE 5 | | 13.69% | | |
| EXAMPLE 5 | | 18.53% | | 35% |
| COMPARATIVE EXAMPLE 6 | | 15.02% | | |
| EXAMPLE 6 | | 18.34% | | 22% |

As can be seen from Table 1, the conversion efficiency of the perovskite solar cell prepared in the present invention is improved by 20% or more compared with that of the solar cells in the comparative examples.

### 2) Measurement of grain size of perovskite light-absorbing layer

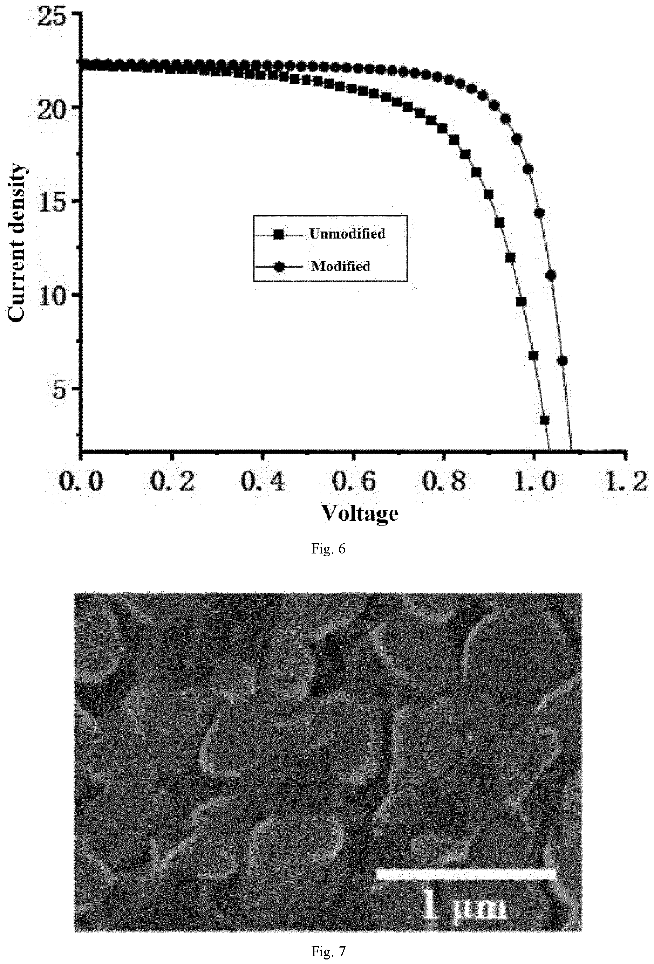

Scanning electron microscope (SEM) images are obtained by using a scanning electron microscope (JSM-7800F, Japan). The test results are shown in Figs. 7 and 8, and the grain sizes are shown in Table 2.

**Table 2 Grain size**

| | Grain size |
|---|---|
| COMPARATIVE EXAMPLE 1 | 0.53 µm |
| EXAMPLE 1 | 1.01 µm |

As can be seen from Table 2 and Figs. 7 and 8, the perovskite light-absorbing layer of the perovskite solar cell prepared in the present invention has a significantly improved grain size, fewer pores and fewer defects compared with the solar cells in the comparative examples.

Obviously, the above-mentioned embodiments are merely examples made for clear description, but do not limit implementations. For those of ordinary skill in the art, other different forms of variations or modifications can also be made on the basis of the above-mentioned description. All embodiments are not necessary to be and cannot be exhaustively listed herein. In addition, obvious variations or modifications derived therefrom all fall within the scope of protection of the present invention.

## Claims

1. A perovskite solar cell, **characterized in that** the perovskite solar cell is sequentially provided with a bottom electrode, an electron transport layer modified by a metal chelating chromogenic agent, a perovskite light-absorbing layer, a hole transport layer and a top electrode; wherein
a preparation method for the perovskite solar cell comprises the following steps:
step 1, preparing an electron transport layer on the bottom electrode;
step 2, coating the surface of the electron transport layer with a solution of the metal chelating chromogenic agent, and performing annealing treatment to form the electron transport layer modified by the metal chelating chromogenic agent;
step 3, preparing the perovskite light-absorbing layer on the electron transport layer modified by the metal chelating chromogenic agent;
step 4, preparing the hole transport layer on the perovskite light-absorbing layer; and
step 5, preparing the top electrode on the hole transport layer.

2. The perovskite solar cell of claim 1, **characterized in that** the metal chelating chromogenic agent is at least one of amino black 10B, Ponceau S, Coomassie brilliant blue and bathophenanthrolinedisulfonate; and/or
the bottom electrode material is FTO conductive glass or ITO conductive glass; and/or
the top electrode material is one of gold, silver or copper; and/or
the top electrode has a thickness of 80-100 nm.

3. A preparation method for the perovskite solar cell of claim 1 or 2, **characterized in that**, in the step 2, the annealing treatment time is 5-10 min, and the annealing treatment temperature is 100±10°C.

4. The preparation method for the perovskite solar cell of claim 3, **characterized in that** the step 1 comprises: spin-coating a tin oxide solution onto the bottom electrode, and performing annealing treatment to prepare the electron transport layer; and
in the step 1, the annealing temperature is 140-160°C, and the annealing time is 25-35 min.

5. The preparation method for the perovskite solar cell of claim 3 or 4, **characterized in that** the step 3 comprises:, spin-coating a mixed solution of lead halide and cesium iodide, and a perovskite precursor solution on the electron transport layer modified by the metal chelating chromogenic agent; and performing annealing treatment to obtain the perovskite light-absorbing layer.

6. The preparation method for the perovskite solar cell of claim 5, **characterized in that** in the step 3, the mixed solution of lead halide and cesium iodide is firstly spin-coated, and the perovskite precursor solution is then spin-coated; and the annealing treatment time is 8-12 min, and the annealing treatment temperature is 100±10°C.

7. The preparation method for the perovskite solar cell of claim 6, **characterized in that** at least one of conditions A-G is satisfied:
A, the lead halide is at least one of lead iodide, lead bromide and lead chloride;
B, a solvent of the mixed solution of lead halide and cesium iodide is at least one of dimethylformamide, chlorobenzene and dimethyl sulfoxide;
C, a mass ratio of lead halide to cesium iodide in the mixed solution of lead halide and cesium iodide is (5-25):(0.2-1.0);
D, the perovskite precursor solution is a mixed solution of ammonium salts comprising formamidine iodide, methyl ammonium iodide, methyl ammonium bromide and methyl ammonium chloride; wherein
a mass ratio of formamidine iodide to methyl ammonium iodide to methyl ammonium bromide to methyl ammonium chloride in the perovskite precursor solution is (2-8):(1-4):(0.25-1.0):(0.25-1.0);
E, a solvent of the perovskite precursor solution is isopropyl alcohol, chlorobenzene or dimethyl sulfoxide;
F, in the step 2, a solvent of the solution of the metal chelating chromogenic agent is at least one of ethanol, isopropanol, chlorobenzene and water; and
G, in the step 2, the concentration of the solution of the metal chelating chromogenic agent is 0.3-2.0 mg/ml.

8. The preparation method for the perovskite solar cell of claim 3 or 4, **characterized in that** the step 4 comprises: spin-coating a Spiro-OMeTAD solution on the perovskite light-absorbing layer to prepare the hole transport layer.

9. The preparation method for the perovskite solar cell of claim 3 or 4, **characterized in that** the step 5 comprises: preparing the top electrode on the hole transport layer by vacuum evaporation.
